# EUROPEAN PATENT APPLICATION

(11) **EP 4 549 371 A1**
(43) Date of publication of application: **07.05.2025**
(21) Application number: 23831133.6
(22) Date of filing: 15.06.2023
(51) Int. Cl.: B81B 1/00, B01J 19/00, B81B 7/04, G01N 35/08, G01N 37/00

(54) **MICROFLUIDIC DEVICE**

(30) Priority: 30.06.2022 JP 2022106726
(71) Applicant: NOK Corporation, Minato-ku Tokyo 105-8585 (JP)
(72) Inventor: FUNAHASHI Akira, Tsujido-shinmachi, Fujisawa-shi, Kanagawa 251- 0042 (JP)
(74) Representative: TBK
(86) International application number: PCT/JP2023/022276
(87) International publication number: WO 2024/004685

(57) **Abstract**

A plurality of microfluidic chips are prepared in which a main chip having a minute space into which a liquid is introduced is held in a guide. These microfluidic chips are connected in a row, and the minute spaces provided in two adjacent main chips are connected by a joint chip. The joint chip is held half each by the respective guides so as to straddle the two adjacent main chips to form a portion of a flow channel including the minute spaces provided in the two main chips. The minute spaces included in the two adjacent main chips and a communication flow path built into the joint chip are connected by a main communication hole of the main chip and a joint communication hole of the joint chip to form a flow channel.

## Description

### Technical Field

The disclosure relates to a microfluidic device.

### Background Art

A microfluidic device is a general term for devices in which minute spaces such as microchannels and reaction vessels are created in a plate-shaped microfluidic chip by a microfabrication technology. Since processing such as separation, stirring, heat treatment, fluorescence detection can be subjected to liquids such as a culture solution, a reagent through the use of minute spaces, the microfluidic device has been used for research in a wide range of fields including biotechnology, life sciences, medicine, and chemical engineering.

In particular, a microfluidic device which handles a liquid within a minute space has been attracting attention as a technology that can reduce the used amount of precious sample. Since plural processing such as liquid separation, stirring, heat treatment, and fluorescence detection can be performed within the same device, they also contribute to shortening of a reaction time.

With such numerous advantages, currently, a microfluidic device is used in a wide range of fields and supports a wide variety of research activities.

On the other hand, since processing contents and the combination of processing steps differ for each individual research, it is necessary to manufacture a dedicated device for each research. The microfluidic device is manufactured from materials such as acrylic, glass, and silicone rubber. No matter which material is selected, its manufacturing takes a lot of time and cost.

Therefore, as seen in Patent Documents 1 to 3, there has been proposed a method of appropriately combining a plurality of microfluidic chips to create a desired microfluidic device.

There has been proposed in Japanese Patent Application Laid-Open No. 2005-147940 (Patent Document 1), a technology of preparing a plurality of types of microfluidic chips with different flow channels and appropriately combining these microfluidic chips on a base member to manufacture a microfluidic device.

Japanese Patent Application Laid-Open No. 2015-123012 (Patent Document 2) discloses that a plurality of types of modules having different functions, which are provided with microchannels respectively, are prepared, and these modules are combined as appropriate to manufacture a microfluidic device corresponding to the purpose of use.

A proposal in International Publication No. 2019/092989 (Patent Document 3) is to stack a plurality of plates for microfluidic chips with different flow channels to manufacture a microfluidic device fit for its intended use.

### Prior Art Documents

### Patent Documents

Patent Document 1: Japanese Patent Application Laid-Open No. 2005-147940
Patent Document 2: Japanese Patent Application Laid-Open No. 2015-123012
Patent Document 3: International Publication No 2019/092989

### Summary

### Problem to be Solved

The microfluidic device described in Japanese Patent Application Laid-Open Nos. 2005-147940 (Patent Document 1) and 2015-123012 (Patent Document 2) is described as a microfluidic device configured by attaching a microfluidic chip or a module to a holder (base member (2) in Patent Document 1 and holder (9) in Patent Document 2)). Therefore, the scale of the microfluidic device depends on the size of the holder, and it is not possible to realize a device which exceeds the size of the holder. Improvements are desired to allow more flexible expansion of a microfluidic device.

In this regard, the microfluidic device described in International Publication No. 2019/092989 (Patent Document 3) has a structure in which the plates of the microfluidic chips are stacked, so that the microfluidic chips can be expanded without increasing the size of each plate. On the other hand, since it is not possible to expose the minute spaces such as the flow channel and the pressure vessel provided in the microfluidic chip located in the lower layer to the outside, it is not possible to observe and detect the liquid as the sample, or add desired processing thereto. It is not suitable for research that require observation of each sample or the like.

It is desired to realize a highly scalable microfluidic device which deploys microfluidic chips in two dimensions.

### Means for Solving the Problem

One aspect of a microfluidic device includes a plate-shaped main chip having a minute space inside into which a liquid is introduced, a plate-shaped joint chip having a communication flow path inside and having on both end sides of an upper surface thereof, a pair of joint communication holes for communicating the communication flow path to the minute space, and a guide. The guide has an upper holding area which holds the main chip, and a lower holding area which selectively holds one of both ends of the joint chip while being partially stacked on the main chip held in the upper holding area. The main chip includes a pair of main communication holes on both end sides of a lower surface of the main chip, the pair of main communication holes communicating the minute space with the joint communication hole of the joint chip held in the lower holding area while being held in the upper holding area.

### Effect

It is possible to obtain a highly scalable microfluidic device which deploys a microfluidic chip in two dimensions.

### Brief Description of Drawings

FIG. 1 is a perspective view illustrating an example of an implementation of a microfluidic device to which a plurality of microfluidic chips are connected;
FIG. 2 is a schematic view illustrating an internal structure of the microfluidic device;
FIG. 3 is a perspective view of a main chip according to a first embodiment;
FIG. 4 is a vertical cross-sectional view of the main chip according to the first embodiment;
FIG. 5 is a perspective view of a main chip according to a second embodiment;
FIG. 6 is a vertical cross-sectional view of the main chip according to the second embodiment;
FIG. 7 is a perspective view of a joint chip according to the first embodiment;
FIG. 8 is a vertical cross-sectional view of the joint chip according to the first embodiment;
FIG. 9 is a perspective view of a joint chip according to the second embodiment;
FIG. 10 is a vertical cross-sectional view of the joint chip according to the second embodiment;
FIG. 11 is a perspective view of a guide;
FIG. 12 is a perspective view of a microfluidic chip according to the first embodiment;
FIG. 13 is a perspective view of a microfluidic chip according to the second embodiment;
FIG. 14 is a schematic view illustrating the microfluidic chip according to the first embodiment with the guide excluded;
FIG. 15 is a schematic view illustrating the microfluidic chip according to the second embodiment with the guide excluded;
FIG. 16 is a perspective view of a joint chip illustrating another embodiment of a seal structure;
FIG. 17 is a perspective view illustrating the joint chip in vertical section;
FIG. 18 is a vertical cross-sectional view of the joint chip; and
FIG. 19 is a perspective view of a microfluidic chip.

### Description of Embodiments

Embodiments will be described with reference to the accompanying drawings. The description will be made along the following items.
1. Configuration
   (1) overall outline
   (2) main chip
      (first aspect)
      (second aspect)
      (common matters)
   (3) joint chip
      (first aspect)
      (second aspect)
      (common matters)
   (4) guide
   (5) microfluidic chip
   (6) another embodiment of seal structure
2. Actions and effects
   (1) actions
   (2) effects
3. Modifications

### 1. Configuration

### (1) overall outline

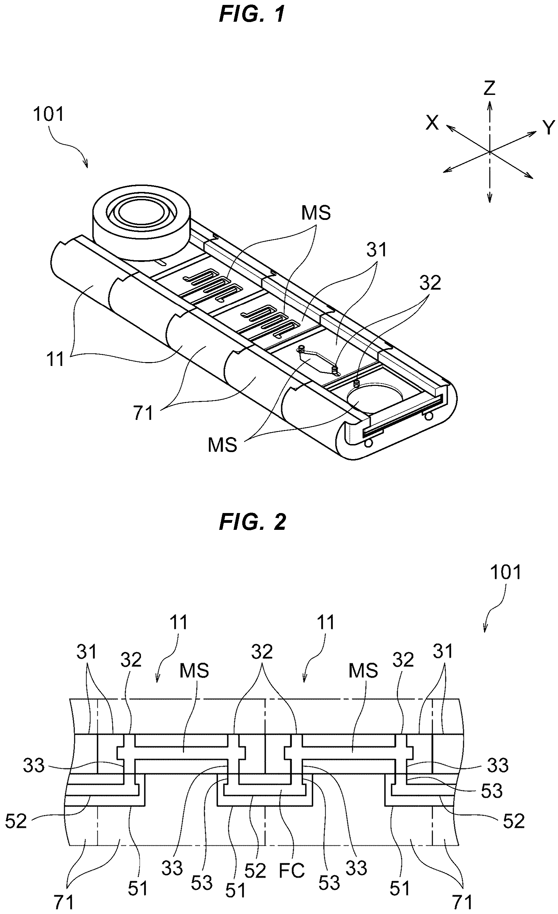

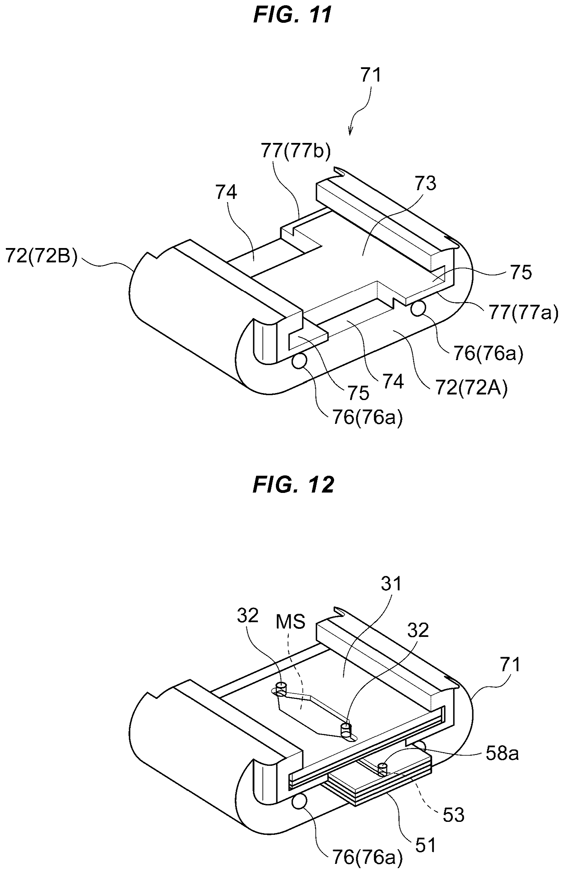

As illustrated in FIG. 1, a microfluidic device 101 according to the present embodiment is configured with a plurality of microfluidic chips 11 connected in a row. Each individual microfluidic chip 11 mainly has a main chip 31 which is internally provided with a minute space MS such as a microchannel or a reaction vessel, and has a structure in which the main chip 31 is held together with a joint chip 51 by a guide 71 (refer to FIGS. 2 and 12).

An X direction in FIG. 1 is the direction of arrangement of the microfluidic chips 11 and defines the length direction of each element. "Both ends" and "ends" of the microfluidic device 101, microfluidic chip 11, main chip 31, joint chip 51, and guide 71 mean both ends and ends in the X direction, respectively.

A Y direction in FIG. 1 is the direction perpendicular to the direction of arrangement of the microfluidic chips 11 and defines the width direction of each element. "Both side ends" and "side parts" of the microfluidic device 101, microfluidic chip 11, main chip 31, joint chip 51, and guide 71 mean both side ends and side parts in the Y direction, respectively.

A Z direction in FIG. 1 defines the vertical direction of the microfluidic device 101, microfluidic chip 11, main chip 31, joint chip 51, and guide 71. The top surface appears above as viewed in the Z direction in FIG. 1, and the bottom surface appears below as viewed in the Z direction in FIG. 1.

As schematically illustrated in FIG. 2, the main chip 31 has the same length (length in the X direction) as the guide 71, and is held by the guide 71 without protruding therefrom. Therefore, when the individual microfluidic chips 11 are arranged in a row and connected, the main chips 31 and guides 71 included in the two adjacent microfluidic chips 11 are in contact with each other at both end surfaces thereof. In the present embodiment, the mutually contacting end surfaces of the two adjacent microfluidic guides 71 are referred to as mounting surfaces 72 (refer to FIG. 11).

The joint chip 51 is arranged in a stack on the two adjacent main chips 31 so as to straddle them.

In the guide 71, the area to hold the main chip 31 is an upper holding area 73, and the area to hold the joint chip 51 is a lower holding area 74 (refer to FIG. 11). When the main chip 31 is correctly held in the upper holding area 73, and the joint chip 51 is correctly held in the lower holding area 74, the main chip 31 and the joint chip 51 are positioned in a stacked and contacting state as illustrated in FIG. 2.

When the individual microfluidic chips 11 are connected in a row, a flow channel FC including the minute space MS is formed. The following elements form the flow channel FC.
▪ Minute space MS of main chip 31,
▪ A pair of supply holes 32 of main chip 31,
▪ A pair of main communication holes 33 of main chip 31,
▪ A communication flow path 52 of joint chip 51, and
▪ A pair of joint communication holes 53 of joint chip 51

When a liquid serving as a sample is introduced from the supply hole 32 of the main chip 31 when a plurality of microfluidic chips 11 are connected in a row to configure a microfluidic device 101, the liquid flows through the flow channel FC.

However, among the elements forming the flow channel FC, the supply hole 32 is essential from the perspective of the entire structure of the microfluidic device 101, but when viewed on the individual microfluidic chip 11 basis, the supply hole 32 is not essential for all microfluidic chips 11. Therefore, the main chips 31 include a type provided with the supply hole 32 and a type without the supply hole 32, which are mixed together.

In FIG. 1, the two main chips 31 on the front side are of a type having supply holes 32, and the two main chips 31 on the back side are of a type without supply holes 32. Thus, when assembling the microfluidic device 101 by combining the desired main chips 31, it is possible to appropriately combine the main chips 31 each having the supply hole 32 and the main chips 31 each having no supply hole 32.

Hereinafter, for convenience of explanation, the main chip 31 provided with the supply holes 32 will be described as an example, but all main chips 31 are not provided with the supply holes 32. As for the main chip 31 of type with no supply holes 32, please note that the supply holes 32 are eliminated from the main chip 31 introduced below.

### (2) Main Chip

### (First Aspect)

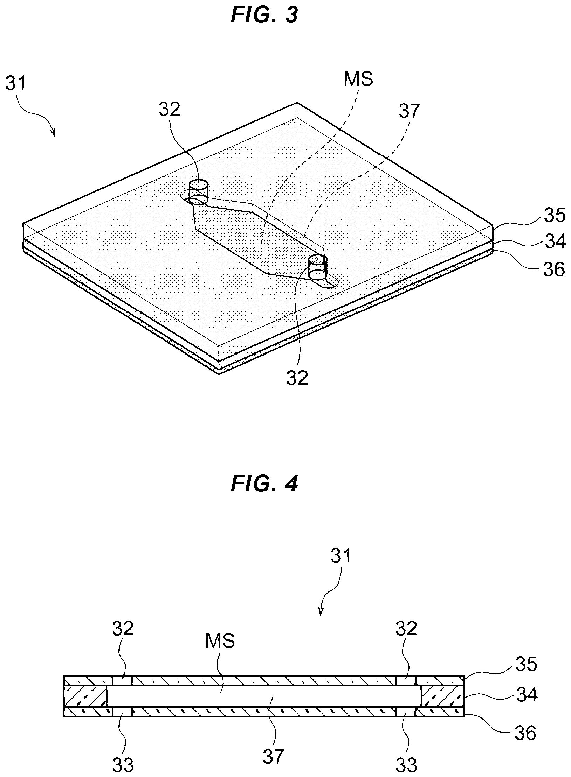

A first aspect of the main chip 31 is illustrated in FIGS. 3 and 4. The main chip 31 is a rectangular-shaped plate-like substrate, and is configured by stacking three acrylic plates each having translucency. They are three of a middle layer main substrate 34, an upper layer main substrate 35, and a lower layer main substrate 36. The main chip 31 is manufactured by positioning the upper layer main substrate 35 on an upper surface of the middle layer main substrate 34 and the lower layer main substrate 36 on a lower surface thereof respectively and thermocompression-bonding them.

All three acrylic plates (34, 35, and 36) use the same shape and size with a 20 mm square. The thickness of the middle layer main substrate 34 is 0.5 mm, the thickness of the upper layer main substrate 35 is 1.0 mm, and the thickness of the lower layer main substrate 36 is 0.5 mm.

The middle layer main substrate 34 is provided with an opening portion 37 which becomes a minute space MS. The shape of the minute space MS defined by the opening portion 37 can be determined as appropriate depending on the use of each individual microfluidic chip 11.

The upper layer main substrate 35 is provided on both end sides with a pair of supply holes 32 communicating with the minute space MS.

The lower layer main substrate 36 is provided on both end sides with a pair of main communication holes 33 communicating with the minute space MS.

The main chip 31, which is completed by thermocompression-bonding the three stacked acrylic plates (34, 35, and 36), has a form in which the minute space MS can be visually recognized from the outside as illustrated in FIG. 1.

The main chip 31 of the type having no supply holes 32 can be manufactured in the same manner by using the plain upper layer main substrate 35 having no supply holes 32.

### (Second Aspect)

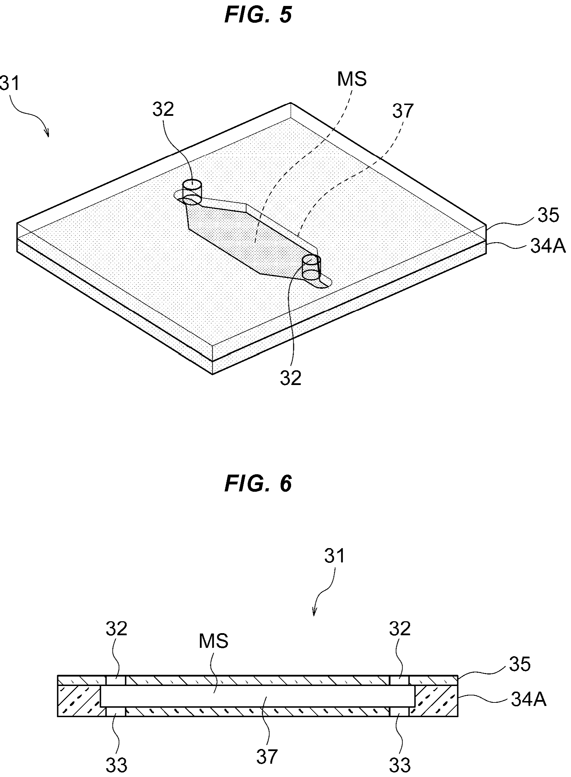

A second aspect of the main chip 31 is illustrated in FIGS. 5 and 6. The main chip 31 is a rectangular-shaped plate-like substrate, and is configured by stacking two acrylic plates each having translucency. They are two of a main substrate 34A and an upper layer main substrate 35. The main chip 31 is manufactured by positioning the upper layer main substrate 35 on an upper surface of the main substrate 34A and bonding it by thermocompression.

Both of the two acrylic plates (34A and 35) forming the two layers use the same shape and size with a 20 mm square. The thickness of both the main substrate 34A and the upper layer main substrate 35 is 1.0 mm.

The main substrate 34A is provided with a minute space MS and a pair of main communication holes 33. The shape of the minute space MS can be determined as appropriate depending on the use of each individual microfluidic chip 11. As for the pair of main communication holes 33, they are provided on both end sides of the main chip 31 so as to communicate with the lower surface of the main substrate 34A.

The upper layer main substrate 35 is provided with a pair of supply holes 32 on both end sides thereof, which communicates with the minute space MS.

The main chip 31, which is completed by thermocompression-bonding the two stacked acrylic plates (34A and 35), has a form in which the minute space MS can be visually recognized from the outside as illustrated in FIG. 1.

The main chip 31 of the type having no supply holes 32 can be manufactured in the same manner by using the plain upper layer main substrate 35 having no supply holes 32.

### (Common Matters)

In implementation, a plurality of types of standardized main chips 31 having various types of minute spaces MS each having a typical shape of a flow path or a reaction vessel may be prepared in advance so that an appropriate selection can be made. The main chip 31 having the supply holes 32 and the main chip 31 having no supply holes 32 can also be similarly standardized. When a minute space MS which is not prepared in advance is required, a main chip 31 (dedicated part) having such a minute space MS is manufactured each time.

The middle layer main substrate 34 and the lower layer main substrate 36 in the first aspect conceptually correspond to the main substrate 34A in the second aspect. In the first aspect, the two acrylic plates (34, 36) are stacked and bonded to generate the main substrate 34A (middle layer main substrate 34, lower layer main substrate 36), and in the second aspect, the single acrylic plate (34A) is used to generate the main substrate 34A (middle layer main substrate34, lower layer main substrate 36). Therefore, it can be said that the difference between the first aspect and the second aspect resides in the method of manufacturing the main substrate 34A.

In terms of such a difference in manufacturing method, it is also possible to integrally shape the main substrate 34A and the upper layer main substrate 35. As an example, a 3D printer can be used to realize an integrally shaped product of the main substrate 34A and the upper layer main substrate 35. A support material is provided in advance in the portions which become the minute space MS, the supply hole 32, and the pair of main communication holes 33 to create modeling inclusive of the support material as well. By removing the support material after the modeling is completed, a plate-shaped main chip 31 is completed which has the minute space MS thereinside and has the supply hole 32 communicating with the minute space MS on its upper surface, and which has the pair of main communication holes 33 on both end sides of its lower surface, which communicates with the minute space MS.

In the present embodiment, there has been shown an example in which the main chip 31 is made of one or more acrylic plates (34 to 36, 34A, and 35), that is, an acrylic resin, but the main chip 31 may be manufactured using as materials, such as polydimethylsiloxane (PDMS), glass, polycarbonate (PC), polyethylene terephthalate (PET), cycloolefin polymer (COP) without being limited to the acrylic resin. In addition to the above, the main chip 31 can be manufactured using various types of materials such as an ABS resin, a PLA resin, an ASA resin (strong in weather resistance), a PP resin (strong in heat resistance and chemical resistance), a PC resin, a nylon resin, an acrylic resin, PETG, thermoplastic polyurethane.

### (3) Joint chip

### (First Aspect)

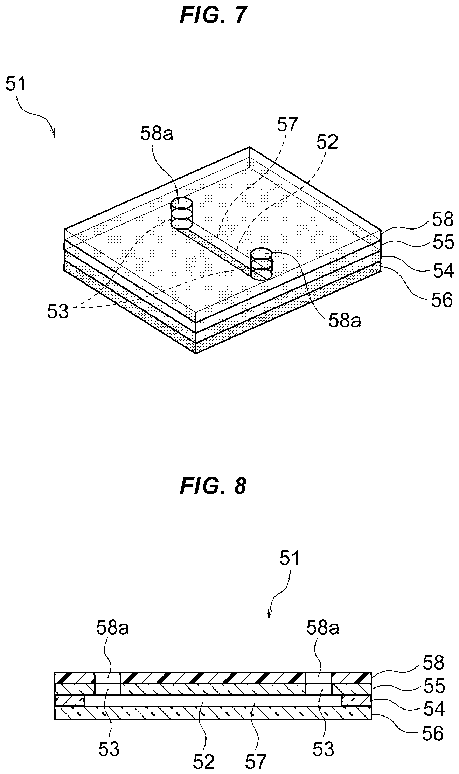

A first aspect of the joint chip 51 is illustrated in FIGS. 7 and 8. The joint chip 51 is a rectangular-shaped plate-like substrate, and is configured by stacking three acrylic plates each having translucency. They are three of a middle layer joint substrate 54, an upper layer joint substrate 55, and a lower layer joint substrate 56. The joint chip 51 is manufactured by positioning the upper layer joint substrate 55 on an upper surface of the middle layer joint substrate 54, and the lower layer joint substrate 56 on its lower surface and bonding them by thermocompression, respectively.

The three acrylic plates (54, 55, and 56) forming the three layers all use the same shape and size with a 10 mm square. They all have the same thickness: the middle layer joint substrate 54 has a thickness of 0.5 mm, the upper layer joint substrate 55 has a thickness of 0.5 mm, and the lower layer joint substrate 56 also has a thickness of 0.5 mm.

The middle layer joint substrate 54 is provided with an opening portion 57 which becomes a communication flow path 52.

The upper layer joint substrate 55 is provided on both end sides with a pair of joint communication holes 53 communicating with the communication flow path 52.

The lower layer joint substrate 56 is a plain acrylic plate with no holes or openings formed therein.

A rubber sheet 58 is bonded to the upper surface of the joint chip 51 completed by thermocompression-bonding the three stacked acrylic plates (54, 55, and 56), i.e., the surface of the upper layer joint substrate 55. The bonding of the rubber sheet 58 to the surface of the upper layer joint substrate 55 is performed by, for example, adhesion. The rubber sheet 58 has the same size and shape as the three acrylic plates (54, 55, and 56) and is bonded thereto without being protruded or displaced from these acrylic plates (54, 55, and 56).

The rubber sheet 58 is provided with a pair of through holes 58a in position alignment with these joint communication holes 53 so as not to block the pair of joint communication holes 53 provided on both end sides of the upper layer joint substrate 55.

### (Second Aspect)

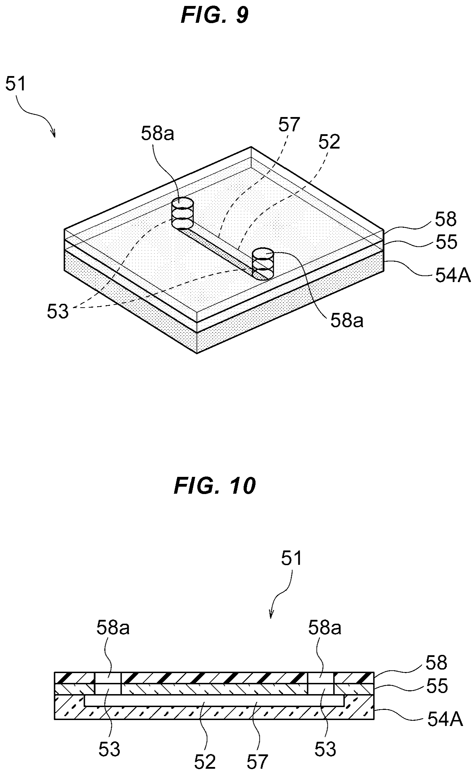

A second aspect of the joint chip 51 is illustrated in FIGS. 9 and 10. The joint chip 51 is a rectangular-shaped plate-like substrate, and is configured by stacking two acrylic plates each having translucency. They are two of a joint substrate 54A and an upper layer joint substrate 55. The joint chip 51 is manufactured by positioning the upper layer joint substrate 55 on an upper surface of the joint substrate 54A and bonding the same by thermocompression.

The two acrylic plates (54A and 55) forming the two layers use the same shape and size, both of which are a 10 mm square. The joint substrate 54A is 1.0 mm in thickness, and the upper layer joint substrate 55 is 0.5 mm in thickness.

The joint substrate 54A is provided with a communication flow path 52.

The upper layer joint substrate 55 is provided on both end sides with a pair of joint communication holes 53 communicating with the communication flow path 52.

A rubber sheet 58 is bonded to the upper surface of the joint chip 51 completed by thermocompression-bonding the two stacked acrylic plates (54A and 55), i.e., the surface of the upper layer joint substrate 55. The bonding of the rubber sheet 58 to the surface of the upper layer joint substrate 55 is performed by, for example, adhesion. The rubber sheet 58 has the same size and shape as the two acrylic plates (54A and 55) and is bonded thereto without being protruded or displaced from these acrylic plates (54A and 55).

The rubber sheet 58 is provided with a pair of through holes 58a in position alignment with the pair of joint communication holes 53 so as not to block these joint communication holes 53 provided on both end sides of the upper layer joint substrate 55.

### (Common matters)

The middle layer joint substrate 54 and the lower layer joint substrate 56 in the first aspect conceptually correspond to the joint substrate 54A in the second aspect. In the first aspect, the two acrylic plates (54 and 56) are stacked and bonded to generate the joint substrate 54A (middle layer joint substrate 54, lower layer joint substrate 56), and in the second aspect, the single acrylic plate (54A) is used to generate the joint substrate 54A (middle layer joint substrate 54, lower layer joint substrate 56), respectively. Therefore, it can be said that the difference between the first aspect and the second aspect resides in the method of manufacturing the joint substrate 54A.

In terms of such a difference in manufacturing method, it is also possible to integrally shape the joint substrate 54A and the upper layer joint substrate 55. As an example, a 3D printer can be used to realize an integrally shaped product of the joint substrate 54A and the upper layer joint substrate 55. A support material is provided in advance in the portions which become the communication flow path 52 and the pair of joint communication holes 53 to create modeling inclusive of the support material as well. By removing the support material after the modeling is completed, a plate-shaped joint chip 51 is completed which has the communication flow path 52 thereinside and has on both end sides of its upper surface, the pair of joint communication holes 53 for allowing the communication flow path 52 to communicate with the minute space MS.

In the present embodiment, there has been shown an example in which the joint chip 51 is made of one or more acrylic plates (54 to 56, 54A, and 55), that is, an acrylic resin, but the joint chip 51 may be manufactured using as materials, such as polydimethylsiloxane (PDMS), glass, polycarbonate (PC), polyethylene terephthalate (PET), cycloolefin polymer (COP) without being limited to the acrylic resin. In addition to the above, the joint chip 51 can be manufactured using various types of materials such as an ABS resin, a PLA resin, an ASA resin (strong in weather resistance), a PP resin (strong in heat resistance and chemical resistance), a PC resin, a nylon resin, an acrylic resin, PETG, thermoplastic polyurethane.

### (4) Guide

As illustrated in FIG. 11, the guide 71 is shaped from, for example, a resin material, and includes the upper holding area 73 whose upper surface is made open, and the pair of lower holding areas 74 on both end sides of the upper holding area 73.

When viewed from the sides of the mounting surfaces 72 located at both ends of the guide 71, the upper portions of both side walls of the upper holding area 73 overhang to face each other to thereby configure a pair of rails 75 which guides the sliding movement of the main chip 31. The main chip 31 is inserted from the mounting surface 72 along these rails 75 and is housed and held in the upper holding area 73. The main chip 31 housed in the upper holding area 73 exposes the minute space MS to the outside from the space between the pair of rails 75, thereby enabling visual recognition and processing operations from the outside.

The pair of lower holding areas 74 are in communication with the mounting surface 72 in a form which is one step lower than the bottom surface of the upper holding area 73. Therefore, the lower holding area 74 opens toward the mounting surface 72 while the main chip 31 is held in the upper holding area 73 and receives mounting of the joint chip 51 by sliding movement. The depth of the lower holding area 74 is set to be half the length of the joint chip 51.

As described above, the multiple microfluidic chips 11 can be connected in their length directions (X direction in FIG. 1). Connecting portions 76 provided in the mounting surface 72 of the guide 71 realizes such a connection between the microfluidic chips 11. The connecting portions 76 are configured by a plurality of magnets 76a embedded into the mounting surface 72.

In the present embodiment, the connection of each individual guide 71 is given directionality. For example, when one guide 71 and another guide 71 are connected, the surfaces to be joined facing each other are determined beforehand. For convenience of explanation, the visible surface located on the front side in FIG. 11 is referred to as the mounting surface 72A, and the invisible surface on the deep side is referred to as the mounting surface 72B. On this premise, when the two guides 71 are connected, the mounting surface 72B of another guide 71 is connected to the mounting surface 72A of one guide 71, and the mounting surface 72A of another guide 71 is connected to the mounting surface 72B of one guide 71.

Therefore, in the connecting portion 76, the magnet 76a embedded in the mounting surface 72A is made different in polarity from the magnet 76a embedded in the mounting surface 72B. As a result, the magnets 76a attract each other with a magnetic force, and the two guides 71 can be connected in a fixed state.

The guide 71 further has a restriction part 77 as well. The restriction part 77 has a structure which restricts the positional displacements of the two guides 71 in a stacking direction of the main chip 31 and the joint chip 51 when the two guides 71 are connected to each other. Such a restriction part 77 is configured by a convex step portion 77a provided on the mounting surface 72A and a concave step portion 77b provided on the mounting surface 72B. The convex step portion 77a protrudes from the mounting surface 72A in the length direction (X direction in FIG. 1). The concave step portion 77b retracts from the mounting surface 72B in the length direction so that they fit into each other.

When the two guides 71 are connected, the convex step portion 77a of one guide 71 fits into the concave step portion 77b of another guide 71, or the concave step portion 77b of one guide 71 fits to the convex step portion 77a of another guide 71 to thereby restrict the positional displacements of the two guides 71 in the stacking direction of the main chip 31 and the joint chip 51.

### (5) Microfluidic Chip

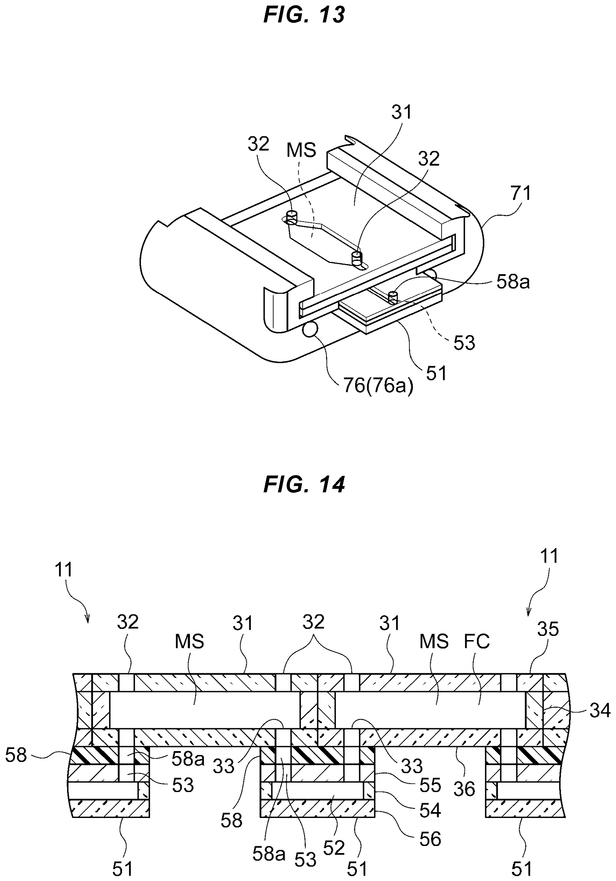

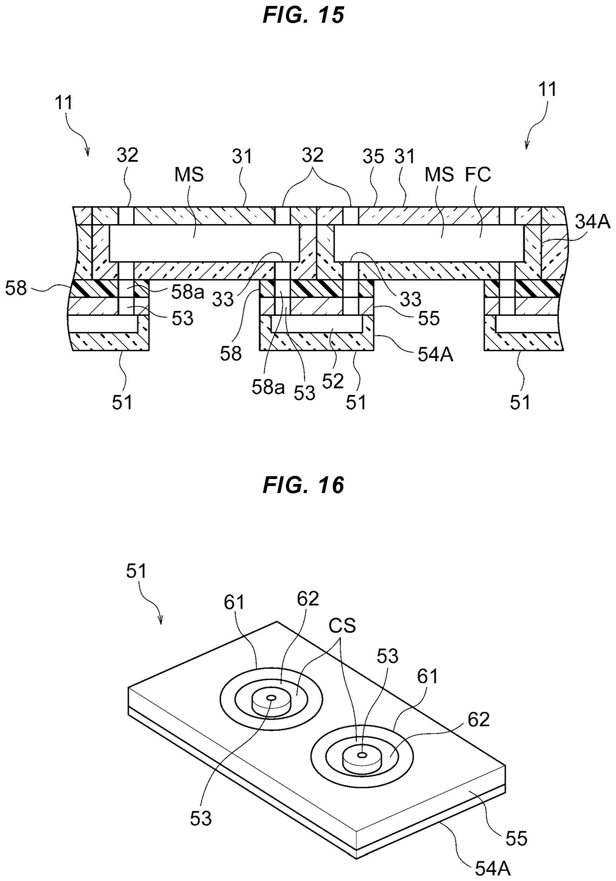

FIG. 12 is a perspective view of the microfluidic chip 11 according to the first embodiment using the main chip 31 and the joint chip 51 in the first embodiment, and FIG. 14 is a schematic view illustrating the microfluidic chip 11 according to the first embodiment with the guide 71 excluded. FIG. 13 is a perspective view of a microfluidic chip 11 according to a second embodiment using a main chip 31 and a joint chip 51 in the second embodiment, and FIG. 15 is a schematic view illustrating the microfluidic chip 11 according to the second embodiment with a guide 71 excluded.

As illustrated in FIGS. 12 and 13, the microfluidic chip 11 is assembled by mounting the main chip 31 on the upper holding area 73 of the guide 71 and mounting the joint chip 51 on the lower holding area 74. The joint chip 51 is inserted and held in the lower holding area 74 by half its length, and the remaining half becomes in a state of protruding from the mounting surface 72. This protruding half of joint chip 51 is inserted and held in a lower holding area 74 provided in a guide 71 of another microfluidic chip 11 connected to the microfluidic chip 11.

Then, as illustrated in FIGS. 14 and 15, the main chip 31 and the joint chip 51 are stacked, and the respective minute spaces MS of the two microfluidic chips 11 are connected to the joint chip 51 to form a flow channel FC.

More specifically, a joint communication hole 53 provided in an upper layer joint substrate 55 of the joint chip 51 communicates with a main communication hole 33 provided in a lower layer main substrate 36 of the main chip 31. Thus, the respective minute spaces MS of the two microfluidic chips 11 are in communication via the main communication hole 33 of one microfluidic chip 11, the joint communication hole 53 on one end side of the joint chip 51 straddling the two microfluidic chips 11, the communication flow path 52, the joint communication hole 53 on the opposite end side thereof, and the main communication hole 33 of the other microfluidic chip 11.

When forming such a flow channel FC, the gap between the stacked main chip 31 and joint chip 51 is sealed by a rubber sheet 58 provided on the upper surface of the joint chip 51 so that the liquid flowing through the flow channel FC is prevented from leaking.

### (6) Another Embodiment of Seal Structure

The seal structure which seals the flow channel FC between the main chip 31 and the joint chip 51 is not limited to the structure using the rubber sheet 58, but can also be achieved by a structure using an O-ring 61.

As illustrated in FIGS. 16 to 18, the upper layer joint substrate 55 of the joint chip 51 is provided with an annular recess 62 so as to surround the circumferences of the pair of joint communication holes 53. When the main chip 31 and the joint chip 51 are held in the upper holding area 73 and the lower holding area 74 of the guide 71, respectively, and the joint chip 51 is superimposed on the main chip 31, the recess 62 forms a communication space CS in which the joint communication hole 53 and the main communication hole 33 connected to each other are located.

The O-ring 61 is fitted into an inner wall 63 forming the recess 62 and slightly protrudes from the surface of the upper layer joint substrate 55, so that the O-ring 61 is brought into contact with the lower layer main substrate 36 (first embodiment) of the main chip 31 or the main substrate 34A thereof (second embodiment). Consequently, the O-ring 61 seals the communication space CS and prevents leakage of the liquid flowing through the flow channel FC at the connecting portion between the main chip 31 and the joint chip 51.

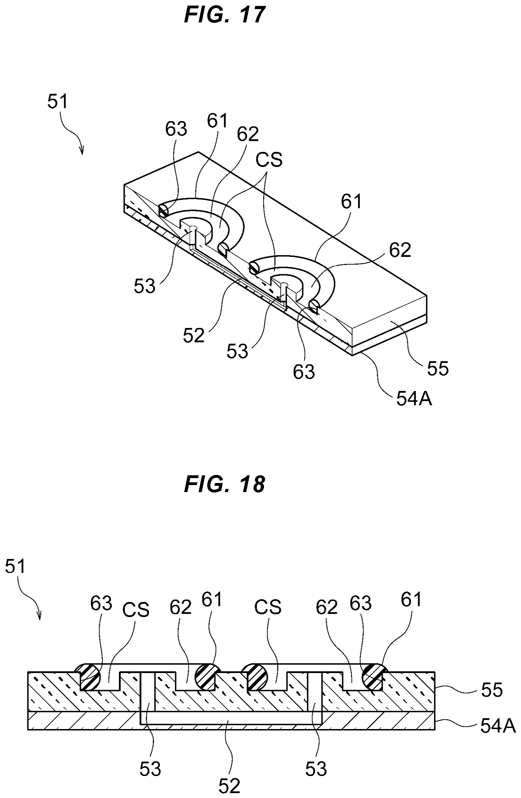

As illustrated in FIGS. 17 and 18, the outer diameter of the O-ring 61 is larger than the inner diameter of the recess 62. The O-ring 61 fitted into the inner wall 63 of the recess 62 is in a state of being elastically deformed and bit into the recess 62.

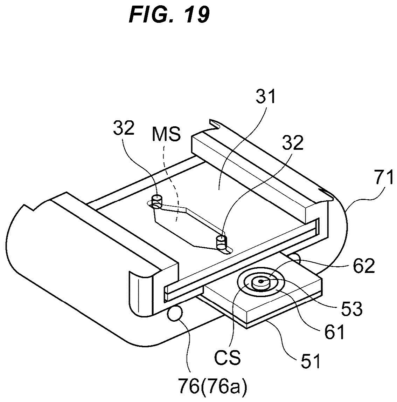

As illustrated in FIG. 19, when the main chip 31 is mounted on the upper holding area 73 of the guide 71, and the joint chip 51 is mounted on the lower holding area 74, the microfluidic chip 11 is assembled. The joint chip 51 is inserted and held in the lower holding area 74 by half its length, and the remaining half becomes into a state of being protruded from the mounting surface 72. The protruded half of the joint chip 51 is inserted and held in the lower holding area 74 provided in the guide 71 of another microfluidic chip 11 connected to the microfluidic chip 11. Thus, the upper layer joint substrate 55 of the joint chip 51 protruding from the guide 71 exposes the O-ring 61 for connection with another main chip 31 held in the guide 71 of another microfluidic chip 11.

The seal structure using the O-ring 61 is applicable even to both the microfluidic chip 11 in the first embodiment and the microfluidic chip 11 in the second embodiment.

### 2. Actions and Effects

### (1)Actions

When the microfluidic device 101 is required, the combination of the microfluidic chips 11 each having the minute space MS suitable for the application is planned, and the microfluidic chips 11 are connected in one row to assemble the microfluidic device 101. When the microfluidic device 101 is used, a liquid such as a culture solution or a reagent is injected into the supply hole 32 prepared on the upper surface of the main chip 31 using an unillustrated pipe or syringe, and the like. Then, the liquid flows through the flow channel FC, and it becomes possible to perform processing such as liquid separation, stirring, heat treatment, fluorescence detection according to the selected minute space MS.

### (2) Effects

The microfluidic device 101 according to the present embodiment has the following effects.

The main chips 31 having the multiple types of minute spaces MS can be rearranged as desired, and the flow channel FC according to the purpose can be easily assembled. At this time, if the flow channel FC can be realized only by combining the main chips 31 each having the standardized minute space MS, the flow channel FC according to the purpose can be created on the spot without preparing special parts.

If the main chips 31 are classified and prepared according to their functions, it is possible to easily perform operations such as surface treatment depending on the purpose of research.

Since all the main chips 31 to be connected are arranged on the same plane, the state of each of the minute spaces MS included in all the main chips 31 can be visually observed, and processing such as fluorescence detection using an optical sensor can also be performed.

There is no limit to the number of the microfluidic chips 11 which can be connected, and excellent expandability can be obtained. In addition, the microfluidic chip 11 can be expanded simply by inserting the main chip 31 and the joint chip 51 from the mounting surface 72 of the guide 71 and connecting the two guides 71, and the workability for expansion is good.

Since the portions constituting the flow channel FC are in an opened state even in the main chip 31 and the joint chip 51, it is easy to clean the inside thereof.

Both the main chip 31 and the joint chip 51 can be easily manufactured simply by stacking and joining the acrylic plates (34, 35, 36, 54, 55, and 56).

Since the space between the main chip 31 and the joint chip 51 can be sealed with the rubber sheet 58, it is possible to prevent the leakage of a liquid. Further, when the two guides 71 are connected, the positional displacements of the main chip 31 and the joint chip 51 in the stacking direction thereof can be restricted by the restriction part 77, and from this viewpoint as well, the leakage of the liquid can be prevented.

The two guides 71 can be easily connected by attraction using the magnetic force of the magnet 76a, and the assembly of the microfluidic device 101 can be facilitated.

### 3. Modifications

Various modifications and changes can be made in implementation.

For example, in the microfluidic chip 11 of the first embodiment, although the specific values for the size and thickness have been given for the three-layer acrylic plates (34, 35, 36, 54, 55, and 56) constituting the main chip 31 and the joint chip 51, they are merely examples. In implementing, the main chip 31 and the joint chip 51 can be manufactured using acrylic plates (34, 35, 36, 54, 55, and 56) of various sizes and thicknesses.

This point is also the same for the microfluidic chip 11 in the second embodiment. The specific values for the size and thickness for the two-layer acrylic plates (34A, 35, 54A and 55) constituting the main chip 31 and the joint chip 51 are merely examples. In implementing, the main chip 31 and the joint chip 51 can be manufactured using acrylic plates (34A, 35, 54A, and 55) of various sizes and thicknesses.

The main chip 31 and the joint chip 51 do not necessarily have to be manufactured by the acrylic plates. The main chip 31 and the joint chip 51 may be manufactured using other types of resin materials, glass, or the like.

The method for joining the acrylic plates is not limited to the thermocompression bonding either, and other methods such as bonding using an adhesive, vacuum compression bonding, and the like may be used.

The connecting portion 76 connecting the two guides 71 may be realized not only by the attraction of the magnets 76a made different in polarity, but also by the magnetic attraction of the magnets 76a to a metal plate, for example. Alternatively, it is not limited the magnets 76a, but any connection structure for connecting two members, such as screwing or clamping, can be applied.

In the above embodiment, the configuration example in which the main chip 31 and the joint chip 51 in the first embodiment are combined has been introduced as the microfluidic chip 11 of the first embodiment, and the configuration example in which the main chip 31 and the joint chip 51 in the second embodiment are combined has been introduced as the microfluidic chip 11 of the second embodiment. The implementation is not limited to this, and the main chip 31 of the first embodiment and the joint chip 51 of the second embodiment, or the main chip 31 of the second embodiment and the joint chip 51 of the first embodiment may be combined to configure the microfluidic chip 11.

Further, the microfluidic device 101 can be configured by freely combining the main chip 31 and the joint chip 51 in the first embodiment, the main chip 31 and the joint chip 51 in the second embodiment, the seal structure using the rubber sheet 58, the seal structure using the O-ring 61, and various modifications and changes of these.

All other modifications and changes are permitted.

### Description of Reference Numerals

- 11: microfluidic chip
- 31: main chip
- 32: supply hole
- 33: main communication hole
- 34A: main substrate
- 34: middle layer main substrate
- 35: upper layer main substrate
- 36: lower layer main substrate
- 37: opening portion
- 51: joint chip
- 52: communication flow path
- 53: joint communication hole
- 54A: joint substrate
- 54: middle layer joint substrate
- 55: upper layer joint substrate
- 56: lower layer joint substrate
- 57: opening portion
- 58: rubber sheet
- 58a: through hole
- 61: O-ring
- 62: recess
- 63: inner wall
- 71: guide
- 72, 72A, 72B: mounting surface
- 73: upper holding area
- 74: lower holding area
- 75: rail
- 76: connecting portion
- 76a: magnet
- 77: restriction part
- 77a: convex step portion
- 77b: concave step portion
- 101: microfluidic device
- CS: communication space
- FC: flow channel
- MS: minute space

## Claims

1. A microfluidic device comprising:
a plate-shaped main chip having a minute space inside into which a liquid is introduced;
a plate-shaped joint chip having a communication flow path inside and having on both end sides of an upper surface of the joint chip, a pair of joint communication holes for communicating the communication flow path to the minute space; and
a guide having an upper holding area which holds the main chip, and a lower holding area which selectively holds one of both ends of the joint chip while being partially stacked on the main chip held in the upper holding area,
wherein the main chip includes a pair of main communication holes on both end sides of a lower surface of the main chip, the pair of main communication holes communicating the minute space with the joint communication hole of the joint chip held in the lower holding area while being held in the upper holding area.

2. The microfluidic device according to claim 1, wherein the main chip has a supply hole for liquid supply on an upper surface of the main chip, the supply hole communicating with the minute space.

3. The microfluidic device according to claim 1, wherein the main chip has an upper layer main substrate bonded to an upper surface of a main substrate having the minute space and the pair of main communication holes.

4. The microfluidic device according to claim 1, wherein the main chip has an upper layer main substrate having the supply hole, which is bonded to the upper surface of the main substrate having the minute space and the pair of main communication holes.

5. The microfluidic device according to claim 3, wherein the main substrate includes:
a middle layer main substrate having an opening portion serving as the minute space, and
a lower layer main substrate having the pair of main communication holes communicating with the opening portion and bonded to a lower surface of the middle layer main substrate so as to close the opening portion which serves as the minute space.

6. The microfluidic device according to claim 3, wherein the main substrate integrally has the minute space and the pair of main communication holes.

7. The microfluidic device according to claim 3, wherein the upper layer main substrate has translucency, and
wherein the guide holds the main chip in the upper holding area with the upper layer main substrate exposed.

8. The microfluidic device according to claim 7, wherein the main substrate and the upper layer main substrate are acrylic plates.

9. The microfluidic device according to claim 1, wherein the joint chip has an upper layer joint substrate having the pair of joint communication holes, which is bonded to an upper surface of a joint substrate having the communication flow path.

10. The microfluidic device according to claim 9, wherein the joint substrate includes:
a middle layer joint substrate having an opening portion serving as the communication flow path, and
a lower layer joint substrate bonded to a lower surface of the middle layer joint substrate so as to close the opening portion serving as the communication flow path.

11. The microfluidic device according to claim 9, wherein the joint substrate integrally has the communication flow path.

12. The microfluidic device according to claim 9, wherein the joint substrate and the upper layer joint substrate are acrylic plates.

13. The microfluidic device according to claim 1, wherein the joint chip has a rubber sheet on an upper surface of the joint chip, and
wherein the rubber sheet has a through hole at the position of the joint communication hole.

14. The microfluidic device according to claim 1, wherein the joint chip has an O-ring surrounding the joint communication hole on an upper surface of the joint chip, and
wherein the O-ring seals a communication space in which the joint communication hole and the main communication hole which communicate with each other are located.

15. The microfluidic device according to claim 1, wherein the guide has a mounting surface on an end surface which holds the joint chip, and
wherein the guide enables the main chip and the joint chip to be inserted from the mounting surface and mounted in the upper holding area and the lower holding area, respectively.

16. The microfluidic device according to claim 15, wherein the guide holds the main chip in the upper holding area without protruding, and
wherein the guide has a connecting portion which detachably connects the mutually facing mounting surfaces of the guide which holds one end of one of the joint chips and the other guide which holds the opposite end of the joint chip.

17. The microfluidic device according to claim 16, wherein the connecting portion connects the mounting surfaces of the two guides by the magnetic force of a magnet embedded in the mounting surface.

18. The microfluidic device according to claim 16, wherein the two guides connected to each other each have a restriction part which restricts positional displacements of the two guides in a stacking direction of the main chip and the joint chip.
